# EUROPEAN PATENT APPLICATION

(11) **EP 4 474 142 A1**
(43) Date of publication of application: **11.12.2024**
(21) Application number: 23756671.6
(22) Date of filing: 17.02.2023
(51) Int. Cl.: B32B 15/04, B32B 7/022, B32B 15/08, B32B 5/24, B32B 27/08, B32B 27/12, B32B 27/18, B32B 27/20, H05K 1/03

(54) **ROLL-TYPE FLEXIBLE METAL LAMINATE, METHOD FOR MANUFACTURING SAME, AND PRINTED CIRCUIT BOARD COMPRISING FLEXIBLE METAL LAMINATE**

(30) Priority: 17.02.2022 KR 20220021065
(71) Applicant: Doosan Corporation, Seoul 04563 (KR)
(72) Inventor: HAN, Gayoung, Yongin-si, Gyeonggi-do 16858 (KR); LEE, Jinsoo, Yongin-si, Gyeonggi-do 16858 (KR); SEO, Hyeonjin, Yongin-si, Gyeonggi-do 16858 (KR)
(74) Representative: Isarpatent
(86) International application number: PCT/KR2023/002320
(87) International publication number: WO 2023/158259

(57) **Abstract**

The present invention relates to a roll-type flexible metal laminate, a method for manufacturing the same, and a printed circuit board comprising the flexible metal laminate, and the method for manufacturing the roll-type flexible metal laminate comprises a first resin composition, which comprises a first high heat-resistant binder, a first fluoropolymer filler and a first organic solvent, and a second resin composition, which is the same as or different from the first resin composition and comprises a second high heat-resistant binder, a second fluoropolymer filler and a second organic solvent; applying the first resin composition onto one surface of a first metal foil, which is continuously supplied, followed by drying at 100 to 180°, thereby preparing a first roll-type unit member comprising the first metal foil and a first resin composition film; applying the second resin composition onto one surface of a second metal foil, which is continuously supplied, followed by drying at 100 to 180°, thereby preparing a second roll-type unit member comprising the second metal foil and a second resin composition film; and laminating the first and second unit members on both surfaces of a fiber-containing substrate, which is continuously supplied, respectively, so that the composition films of the unit members are in contact with the surface of the fiber-containing substrate, followed by heating and pressing at 300 to 400°C.

## Description

### Technical Field

The present invention relates to a roll-type flexible metal clad laminate, a method for manufacturing the same, and a printed circuit board including the flexible metal clad laminate and, specifically, to a roll-type flexible metal clad laminate, which can be applied to a roll-to-roll process and used for a printed circuit board for high-frequency to ultra-high frequency applications.

### Background Art

As the era of hyper-connected intelligence, including artificial intelligence, big data, and self-driving cars, has recently arrived, various electronic devices such as smartphones have been rapidly developed and distributed, and consequently, next-generation 5G communications capable of wirelessly transmitting large-capacity data at high speed are emerging instead of existing 4G LTE communications. With 5th generation mobile communications (5G) emerging as a core infrastructure technology of the 4th Industrial Revolution, there is an increasing interest and significance in 5G. For the spread of self-driving cars, smart cities, and smart factories, next-generation communication technology for connection and real-time processing of large amounts of data without delay has become essential. 5G enables operation at high frequencies (above 26 GHz), i.e., mmWave 5G, the simultaneous transmission of large amounts of data, and the implementation of high-precision images due to high resolution. Nevertheless, high frequencies incur significant losses resulting from the conversion of signals into heat. Therefore, low-loss materials with a low dielectric constant and low dielectric loss need to be designed for performance at high frequencies without losses of signals.

Dielectric substrates used in the high frequency bands for 5G communications need to have a low dielectric constant (Dk) and dielectric loss tangent (Df) to minimize propagation loss. Due to this reason, polyimides (PIs), materials mainly used in existing 4G LTE communications, have limitations. Therefore, to minimize propagation loss in the high frequency band for 5G communications, there is a need to develop dielectric materials with a low dielectric constant (Dk) and dielectric loss tangent (Df) and printed circuit boards using the same.

### Disclosure of Invention

### Technical Problem

An aspect of the present invention is to manufacture a roll-type flexible metal laminate through in-line processing as a single continuous process.

Another aspect of the present invention is to provide a roll-type flexible metal laminate and a method for manufacturing the same, wherein the metal laminate can be used for roll-to-roll processing, possesses low-dielectric properties, and exhibits excellent thermal and mechanical properties.

Still another aspect of the present invention is to provide a printed circuit board including the foregoing roll-type flexible metal laminate.

### Solution to Problem

In accordance with an aspect of the present invention, there is provided a method for manufacturing a roll-type flexible metal laminate, the method including: preparing a first resin composition, which contains a first high heat-resistant binder, a first fluoropolymer filler, and a first organic solvent, and a second resin composition, which is the same as or different from the first resin composition and contains a second high heat-resistant binder, a second fluoropolymer filler, and a second organic solvent; applying the first resin composition onto one surface of a first metal foil, which is continuously supplied, followed by drying at 100 to 180°C, thereby preparing a first roll-type unit member containing the first metal foil and a first resin composition film; applying the second resin composition onto one surface of a second metal foil, which is continuously supplied, followed by drying at 100 to 180°C, thereby preparing a second roll-type unit member containing the second metal foil and a second resin composition film; and laminating the first and second unit members on both surfaces of a fiber-containing substrate, which is continuously supplied, respectively, such that the composition films of the unit members are in contact with the surfaces of the fiber-containing substrate, followed by heating and pressing at 300 to 400°C.

The first resin composition may further contain a first inorganic filler, and the second resin composition may further contain a second inorganic filler, which is the same as or different from the first inorganic filler.

In accordance with another aspect of the present invention, there is provided a roll-type flexible metal laminate, including: a fiber-containing substrate; a first resin layer disposed on one surface of the substrate; a second resin layer disposed on the other surface of the substrate, the second resin layer being the same as or different from the first resin layer; and first and second metal foils disposed on the first and second resin layers, respectively, wherein the first resin layer contains a first high heat-resistant binder and a first fluoropolymer filler, and the second resin layer is the same as or different from the first resin layer and contains a second high heat-resistant binder and a second fluoropolymer filler.

The first resin layer may further contain a first inorganic filler, and the second resin layer may further contain a second inorganic filler, which is the same as or different from the first inorganic filler.

In accordance with still another aspect of the present invention, there is provided a flexible printed circuit board including the forgoing roll-type flexible metal laminate.

### Advantageous Effects of Invention

According to the present invention, a roll-type flexible metal laminate can be easily manufactured through in-line processing as a single continuous process by using a resin composition containing a high heat-resistant binder, a fluoropolymer filler, and an organic solvent.

Furthermore, the resin composition is coated directly on a metal foil and dried, without high-temperature extrusion molding and firing for forming a resin film in the manufacture of a roll-type flexible metal laminate, thereby ensuring excellent adhesive strength between a resin composition film and the metal foil and improving working efficiency in thermal compression between the unit member and the fiber-containing substrate. Additionally, the present invention can ensure the simplification of manufacturing processes, a reduction in manufacturing costs, and a shortening of manufacturing time, leading to an improvement in production efficiency.

### Brief Description of Drawings

FIG. 1 is a cross-sectional view schematically illustrating a process for manufacturing a roll-type flexible metal laminate according to an embodiment of the present invention.
FIG. 2 is a cross-sectional view schematically illustrating a roll-type flexible metal laminate according to an embodiment of the present invention.

### ** Explanation of reference numerals **

10: Roll-type flexible metal lamina
11: Fiber-containing substrate
12a: First resin composition film
12b: Second resin composition film
12A: First resin layer
12B: Second resin layer
13A: First metal foil
13B: Second metal foil
C1: First resin composition
C2: Second resin composition
Unit-A: First unit member
Unit-B: Second unit member

### Best Mode for Carrying out the Invention

Hereinafter, preferred embodiments according to the present invention will be described in detail with reference to the accompanying drawings. The present invention may, however, be embodied in many different forms and should not be construed as being limited to the embodiments set forth herein. Rather, these embodiments are provided so that this disclosure will be thorough and complete, and will fully convey the concept of the invention to those skilled in the art. As used herein, like numbers refer to like elements throughout.

Unless otherwise defined, all terms (including technical and scientific terms) used herein have the same meaning as commonly understood by one of ordinary skill in the art to which this inventive concept belongs. In addition, terms defined in a commonly used dictionary are not to be interpreted ideally or excessively unless clearly defined in particular.

Since the size and the thickness of each element shown in the drawings are arbitrarily indicated for better understanding and ease of description, the present invention is not limited to as shown in the drawings. In the drawings, the thicknesses of several layers and regions are enlarged so as to clearly express the layers and the regions. Moreover, in the drawings, the thicknesses of some layers and regions are exaggerated for convenience of explanation.

Throughout the specification, when a part is said to "comprise", "include", or "contain" a certain element, it means that other elements may be further included, rather than excluding other elements, unless otherwise stated.

In addition, throughout the specification, "on" or "above" means not only when it is located on or beneath a target part, but also includes the case where there is another part therebetween, and does not mean that it is located upwardly with respect to the direction of gravity.

In the present specification, terms such as "first" and "second" do not indicate any order or importance but are used to distinguish components from each other.

### <Manufacturing method of roll-type flexible metal laminate>

Fluoropolymer resins with a low dielectric constant (Dk) and dielectric loss tangent (Df) are emerging to minimize the propagation loss in the high frequency band for 5G communications. However, fluoropolymers are thermoplastic and have a melting point as high as about 300°C or higher. Therefore, conventionally, in order to form low-dielectric substrates (insulating layers) used in communication circuits using fluorine resins, a high-temperature sintering process was performed for a long time under conditions of a high temperature of approximately 300 °C or higher and a high pressure, and the low-dielectric substrates were produced only in a sheet type, resulting in poor productivity and mass production and high manufacturing costs.

According to the present invention, roll-type flexible metal laminates can be easily manufactured through in-line processing as a single continuous process by using a resin composition containing a high heat-resistant binder, a fluoropolymer filler, an organic solvent, and, if necessary, an inorganic filler. In the present invention, the resin composition is coated directly on a metal foil and dried to form a unit member including the metal foil and a dried material of the resin composition (hereinafter, referred to as "resin composition film"), and then the unit member is bound to a fiber-containing substrate to produce a roll-type flexible metal laminate. That is, the present invention requires no high-temperature extrusion molding and firing processes for forming a resin-only film since the resin composition is not filmed on a separate substrate. Consequently, the present invention can not only simplify the manufacturing process, but also achieve a reduction in manufacturing costs and a shortening of manufacturing time, leading to an improvement in production efficiency. Furthermore, unlike the conventional art where a resin-only film is separately formed and then compressed on a metal foil, a resin composition is coated directly on a metal foil, thereby securing very high adhesive strength between the resin composition film and the metal foil, leading to an improvement in working efficiency upon the thermal compression between a unit member and a fiber-containing substrate. Furthermore, the resin composition film is adjusted to have a porosity in a particular range during the formation of the unit member. Therefore, the resin composition film has high thermal conductivity and a low melting point (Tm), so that a roll-type flexible metal plate can be easily manufactured even though the compression time is short or the compression temperature is low upon the thermal compression between the unit member and the fiber-containing substrate.

According to one embodiment, a method for manufacturing a roll-type flexible metal laminate, specifically, a method for manufacturing a roll-type double-sided flexible metal laminate includes: preparing a first resin composition, which contains a first high heat-resistant binder, a first fluoropolymer filler, and a first organic solvent, and a second resin composition, which is the same as or different from the first resin composition and contains a second high heat-resistant binder, a second fluoropolymer filler, and a second organic solvent (S100); applying the first resin composition onto one surface of a first metal foil, which is continuously supplied, followed by drying at 100 to 180°C, thereby preparing a first roll-type unit member containing the first metal foil and a first resin composition film (S200); applying the second resin composition onto one surface of a second metal foil, which is continuously supplied, followed by drying at 100 to 180°C, thereby preparing a second roll-type unit member containing the second metal foil and a second resin composition film (S300); and laminating the first and second unit members on both surfaces of a fiber-containing substrate, which is continuously supplied, respectively, such that the composition films of the unit members are in contact with the surfaces of the fiber-containing substrate, followed by heating and pressing at 300 to 400°C (S400). However, the method of the present invention is not limited to only the forgoing manufacturing method, and each process steps may be modified or selectively mixed, if necessary.

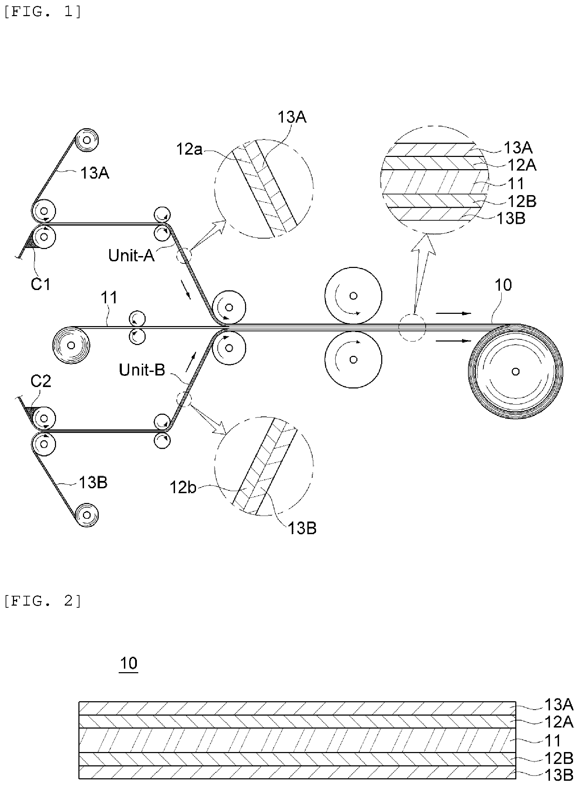

Hereinafter, respective steps for manufacturing a roll-type double-sided flexible metal laminate according to the present invention will be described with reference to FIG. 1.

### Step S100: Step of preparing first and second resin compositions

First, a first resin composition C1 and a second resin composition C2 are prepared. The first resin composition C1 and the second resin composition C2 are the same as or different from each other, and may be prepared separately or simultaneously.

The first resin composition C1 of the present invention may contain a first high heat-resistant binder, a first fluoropolymer filler, and a first organic solvent, and may optionally further contain a first inorganic filler and/or a first additive.

Hereinafter, the first resin composition C1 will be described.

### (a) First high heat-resistant binder

The first resin composition C1 of the present invention contains a first high heat-resistance binder. The first high heat-resistance binder, which is a binder resin with excellent high-temperature heat resistance, may bind a first fluoropolymer filler and a first inorganic filler in the formation of a first unit member. The first high heat-resistant binder can enhance adhesive characteristics between a first resin composition film and a metal foil due to excellent adhesive strength (sticking strength) to the first metal foil.

The first high heat-resistant binder may have a thermal decomposition temperature (Td) of about 400°C or higher, specifically in the range of about 400 to 450°C.

The first high heat-resistant binder may have a dielectric loss tangent (Df) in the range of about 0.0005 to 0.003 at 10 GHz and a dielectric constant (Dk) in the range of about 2.0 to 3.0 at 10 Hz. Such properties can improve low-dielectric characteristics of a first resin layer within a final flexible metal laminate.

The first high heat-resistant binder may have a melt flow rate (MFR) of about 0.01 g/10 min or less under conditions of 230°C and 2 kg. Herein, the MFR of the binder may be measured according to ISO 1133-1 or the like.

A solution obtained by dissolving 5 wt% of the first high heat-resistant binder in an organic solvent (e.g., toluene) may have a viscosity of about 50 to 100 cPs. In such a case, the viscosity of the first resin composition of the present invention may be adjusted to be within the range of about 150 to 500 cPs, thereby improving processability during the manufacturing of a roll-type flexible metal laminate.

In one embodiment, the first high heat-resistant binder may be a fluorine-based elastomer.

The fluorine-based elastomer is a thermoplastic elastomer containing at least one fluorine (F) atom in at least one repeating unit, and has a high thermal decomposition temperature (Td) of about 390°C or higher, and specifically 400°C or higher, and a low dielectric loss tangent and dielectric constant. Examples of the fluorine-based elastomer include fluoro elastomers (FKM), specifically include: copolymers containing two or more of vinylidene fluoride (VDF), hexafluoropropylene (HFP), and tetrafluoroethylene (TFE); tetrafluoroethylenepropylene-based copolymers; vinylidene fluoride-tetrafluoroethylene-hexafluoropropylene copolymers; and tetrafluoroethylene-perfluoroalkyl vinyl ether-based copolymers, but are not limited thereto. These may be used alone or in mixture of two or more thereof.

The content of fluorine (F) in these fluorine-based elastomers is not particularly limited, but about 65 to 80 wt% of fluorine per one molecule of a corresponding fluorine-based elastomer can impart excellent low-dielectric characteristics and low-dielectric loss characteristics to a first resin layer 12A.

In the first resin composition C1, the content of the first high heat-resistant binder may be in the range of about 1 to 10 wt%, specifically about 3 to 7 wt% relative to the total amount of the first resin composition (provided that the organic solvent is excluded). Less than about 1 wt% of the first high heat-resistant binder may cause a poor effect in binding fillers, and more than 10 wt% of the first high heat-resistant binder may result in poor adhesive strength to a fiber-containing substrate 11 as well as a first metal foil (e.g., copper foil) 13A, causing the peeling of the first metal foil during the manufacture or use of the roll-type flexible metal laminate.

### (b) First fluoropolymer filler

In the first resin composition C1, a first fluoropolymer filler (first fluororesin filler), which corresponds to fluorine-based resin particles containing fluorine (F), is an organic filler in a particle type, such as a powder or fibers, having a predetermined shape in a solid state at room temperature (about 20 ± 5°C). The first fluoropolymer filler is bound, in the form of particles, to the first high heat-resistant binder together with the first inorganic filler upon the drying of the first resin composition and thus contained in the first resin composition film 12a, and subsequently melted by a high-temperature press to be contained in the first resin layer 12A as a polymer matrix. Therefore, the first fluoropolymer filler can implement low-dielectric constant and low-dielectric loss characteristics of the first resin layer 12A as well as improve the adhesiveness and heat resistance between the fiber-containing substrate 11 and the first metal foil 13A.

The first fluoropolymer filler may have a melting point (Tm) in the range of about 320°C or lower, specifically in the range of about 280 to 320°C. In such a case, upon the binding of the first unit member Unit-A and the fiber-containing substrate 11, the first fluoropolymer filler may be easily melted even under low heat capacity due to a short pressing time or a low heating temperature. Particularly, the molten first fluoropolymer filler is fired while binding with the first inorganic filler and thus is contained in the first resin layer 12A, as one component of the polymer matrix.

The first fluoropolymer filler may have a dielectric constant (Dk) of about 2.1 or less and a dielectric loss tangent (Df) of about 0.0002 or less at 1 to 100 Hz. As described above, the first fluoropolymer filler has a low dielectric loss tangent and a low dielectric constant, thereby implementing low dielectric constant and low dielectric loss characteristics of the first resin layer 12A.

The first fluoropolymer filler may have a melt flow rate (MFR) of about 1 to 50 g/10 min under conditions of about 372°C and about 5 kg. The MFR of the filler may be measured according to ISO 1133-1 or the like.

The fluoropolymer filler usable in the present invention is not particularly limited as long as it is in the form of particles formed of a fluorine-containing resin in the art. Examples of the fluoropolymer filler include polytetrafluoroethylene (PTFE), perfluoroalkoxy alkane (PFA), tetrafluoroethylene-hexafluoropropylene copolymer (FEP), polychlorotrifluoroethylene (PCTFE), ethylene-tetrafluoroethylene copolymer (ETFE), tetrafluoroethylene-chlorotrifluoroethylene copolymer (TFE/CTFE), ethylene-chlorotrifluoroethylene copolymer (ECTFE), polychlorotrifluoroethylene (PCTFE), and the like, but are not limited thereto. Among these, PFA and PTFE are preferable due to a Df as low as 0.0002 or less.

The first fluoropolymer filler may have a maximum particle diameter of about 0.01 to 30 µm. In such a case, the first resin composition film 12a has a porosity as low as about 80 to 100% and therefore has high thermal conductivity, so that the first resin layer 12A can be easily formed in spite of a short pressing time when the first unit member Unit-A and the fiber-containing substrate 11 are bound. Furthermore, improved handleability can be achieved after coating of the first resin composition.

The first fluoropolymer filler may have an average particle diameter (D50) in the range of about 0.01 to 30 µm. When the first fluoropolymer filler has the foregoing average particle diameter (D50), the first fluoropolymer filler can be not only uniformly dispersed without agglomeration in the first resin composition, but also ensure improve handleability after coating of the first resin composition. Additionally, when the first fluoropolymer filler has the foregoing average particle diameter (D50), the packing density of the first resin layer may be about 2.1 to 2.4 g/ml. In the present invention, one type of first fluoropolymer fillers having the same average particle diameter (D50) may be used alone, or two or more types of first fluoropolymer fillers having different average particle diameters (D50) may be used in mixture.

The shape of the first fluoropolymer filler is not particularly limited, and examples thereof include spherical, flaky, dendritic, conical, pyramidal, and amorphous shapes, which may be used alone or in mix of two or more types thereof. In one embodiment, the shape of the first fluoropolymer filler may be spherical. In such a case, the surface area of the first fluoropolymer filler can be minimized, leading to an improvement in processing characteristics of the first resin composition and imparting isotropic characteristics to the first resin layer.

In the first resin composition C1, the content of the first fluoropolymer filler is not particularly limited. Too small a content of the first fluoropolymer filler may reduce the adhesive strength to the fiber-containing substrate 11 as well as the adhesive strength to the first metal foil (e.g., copper foil) 12A, causing the peeling of the first metal foil 13A. On the other hand, too large a content of the first fluoropolymer filler may result in a relatively small content of the first inorganic filler, thereby decreasing the coefficient of thermal expansion (CTE) of the first resin layer. Therefore, the content of the first fluoropolymer filler is preferably adjusted to be in the range of about 40 to 95 wt%, specifically about 55 to 80 wt%, relative to the total amount of the first resin composition (provided that the organic solvent is excluded).

### (c) First organic solvent

The first resin composition C1 of the present invention contains an organic solvent. The organic solvent usable in the present invention is not particularly limited as long as it can dissolve the above-described elastomer therein. Examples of the organic solvent include: aromatic compounds such as toluene, xylene, and ethylbenzene; alcohol-based compounds, such as methanol, ethanol, butanol, and isobutanol; ketone-based compounds, such as acetone, methyl isobutyl ketone, methyl amyl ketone, cyclohexanone, isophorone, and N-methyl pyrrolidone; and ester-based compounds, such as ethyl acetate, butyl acetate, and methyl cellosolve acetate, but are not limited thereto. These may be used alone or in mixture of two or more thereof.

The organic solvent may be used in a content known in the art, and may be used in a residual amount adjusted so that the total amount of the resin composition is 100 wt%. In one embodiment, the content of the organic solvent may be in the range of about 40 to 70 parts by weight, specifically about 45 to 65 parts by weight, relative to 100 parts by weight of the first resin composition (provided that the organic solvent is excluded).

### (d) First inorganic filler

The first resin composition C1 of the present invention may further contain a first inorganic filler. The first inorganic filler reduces the difference in coefficient of thermal expansion (CTE) between the first resin layer 12A formed of the first resin composition and another layer (e.g., the fiber-containing substrate 11 or the first metal foil 13A), thereby effectively improving the flexure characteristics, low expansion, mechanical strength (toughness), and low stress of a final product.

Non-limiting examples of the inorganic filler usable in the present invention include silica (such as natural silica, fused silica, amorphous silica, and crystalline silica), boehmite, alumina, talc, glass (e.g., spherical glass), calcium carbonate, magnesium carbonate, magnesia, clay, calcium silicate, titanium oxide, antimony oxide, glass fibers, aluminum borate, barium titanate, strontium titanate, calcium titanate, magnesium titanate, bismuth titanate, titania (e.g., TiO₂), barium zirconate, calcium zirconate, boron nitride, silicon nitride, talc, mica, and the like. These inorganic fillers may be used alone or in mixture of two or more thereof. Among these, silica, alumina, and titania have a low dielectric constant and thus can reduce the difference in coefficient of thermal expansion between the resin layer and the metal foil and lower the dielectric constant and the dielectric loss tangent. In one embodiment, the inorganic filler may include at least one selected from the group consisting of silica (e.g., SiO₂), alumina (e.g., Al₂O₃), and titania (e.g., TiO₂).

The size (e.g., average particle diameter), shape, and content of the first inorganic filler are important parameters that affect the characteristics of the first resin layer.

Specifically, the first inorganic filler may have an average particle diameter (D50) in the range of about 1 to 20 µm. This range is advantageous in terms of the dispersibility of the first inorganic filler.

The shape of the first inorganic filler is not particularly limited, and examples thereof include spherical, flaky, dendritic, conical, pyramidal, and amorphous shapes.

In the present invention, one type of first inorganic fillers having the same shape and average particle diameter may be used alone, or a mixture of two or more types of first inorganic fillers having different shapes and average particle diameters may be used.

In the first resin composition of the present invention, the content of the first inorganic filler is not particularly limited and may be appropriately adjusted in consideration of the foregoing flexure characteristics, mechanical properties, and the like. However, an excessive amount of the first inorganic filler is disadvantageous in moldability and may reduce the adhesive strength of the first resin layer. In one embodiment, the content of the first inorganic filler may be about 0 to 45 wt%, specifically exceeding about 0 to not exceeding 45 wt%, relative to the total amount of the first resin composition (provided that the organic solvent is excluded).

### (f) First additive

The first resin composition C1 of the present invention may further contain, if necessary, a first additive, such as a flame retardant, another thermo-curable resin or thermoplastic resin, an ultraviolet absorber, an antioxidant, a polymerization initiator, a dye, a pigment, a dispersant, a thickener, a leveling agent, or a colorant, known in the art within the range that impairs the properties of the composition, in addition to the foregoing first high heat-resistant binder, first fluoropolymer filler, first organic solvent, and first inorganic filler.

The content of the first additive may be employed as known in the art, and for example, may be about 0.0001 to 10 wt% relative to the total amount of the first resin composition.

The second resin composition C2 of the present invention may contain a second high heat-resistant binder, a second fluoropolymer filler (second fluororesin filler), and a second organic solvent, and may optionally further contain a second inorganic filler and/or a second additive. The composition (type and/or content of each component) of the second resin composition may be the same as or different from that of the first resin composition. In one embodiment, the first resin layer 12A is the same as the second resin layer 12B since the first resin composition is the same as the second resin composition.

Since the features of the second high heat-resistant binder, second fluoropolymer filler, second organic solvent, second inorganic filler, and second additive overlap with those of the first high heat-resistant binder, first fluoropolymer filler, first organic solvent, inorganic filler, and first additive of the first resin layer, the descriptions thereof are omitted.

The viscosities of the first and second resin compositions according to the present invention may be adjusted depending on the types or contents of the binders, inorganic fillers, fluoropolymer fillers, organic solvents, and the like in the compositions, and may be, for example, about 150 to 500 cPs. In one embodiment, when the first and second resin compositions have the foregoing viscosities, the first resin composition film 12a and the second resin composition film 12b may be formed directly on the first and second metal foils 13A and 13B by applying the first and second resin compositions directly on the first and second metal foils, respectively, through roll-to-roll coating and then drying the same.

### Step S200: Step of preparing first unit member

The first resin composition C1 prepared in step S100 is applied onto one surface of the continuously supplied first metal foil 13A, followed by drying, thereby preparing a roll-type first unit member Unit-A including the first metal foil 13A and a first resin composition film 12a.

Specifically, the first resin composition C1 is directly applied (coated) on one surface of the first metal foil 13A, which is continuously supplied from first metal foil supply rollers, followed by drying at about 100 to 180°C, thereby preparing a roll-type first unit member Unit-A in which a film 12a (hereinafter, referred to as "first resin composition film 12a"), obtained by removal of the solvent from the applied first resin composition C1, is formed on one surface of the first metal foil 13A. As such, the roll-type first unit member Unit-A can be prepared by coating and drying the first resin composition C1 directly on the first metal foil 13A without a filming process (paste extrusion and calendering) and a high-temperature firing process. Particularly, the first resin composition film 12a can enhance the durability of a final flexible metal laminate due to excellent adhesive strength to the first metal foil 13A.

In the present invention, the first metal foil 13A may employ any typical metal component that is applied to flexible metal laminates or flexible printed circuit boards in the art, without particular limitation. For example, each metal foil may be a metal thin film of one type or an alloy thin film of two or more types selected from the group consisting of copper (Cu), iron (Fe), nickel (Ni), titanium (Ti), aluminum (Al), silver (Ag), and gold (Au). Preferably, the first metal foil 13A may be a copper foil that has excellent electrical conductivity and is inexpensive. Particularly, any typical copper foil known in the art may be used without limitation, and all copper foils manufactured by rolling and electrolysis methods may be used.

Additionally, the surface of the first metal foil 13A in contact with the first resin composition film 12a may be a roughened surface having a predetermined surface roughness. The average roughness (Rz) of the roughened surface may be about 0.5 to 3 µm. In such a case, the present invention exhibits excellent transmission characteristics in the high frequency to ultra-high frequency band.

The thickness of the first metal foil 13A is not particularly limited, and may be in the range of about 1 to 50 µm, specifically about 1 to 30 µm, considering the thickness and mechanical properties of a final flexible metal laminate.

The direct application (coating) method is not particularly limited, and includes, for example, roll-to-roll coating, and specifically comma coating, slot die coating, curtain coating, and spray coating.

The drying of the first resin composition C1 is conducted to remove the first organic solvent in the first resin composition by drying. The drying may be conducted at a temperature of about 100 to 180°C for about 3 to 30 minutes, thereby forming the first resin composition film 12a on the first metal foil 13A. As described above, the present invention involves just drying the first resin composition prior to pressing, but not high-temperature firing at 350°C or higher.

As shown in FIG. 1, the first unit member Unit-A manufactured through the present step includes the first metal foil 13A and the first resin composition film 12a disposed on one surface of the first metal foil 13A. The first metal foil 13A and the first resin composition film 12a are integrated with each other.

In one embodiment, the first resin composition film 12a may have a porosity of about 80 to 100%.

In another embodiment, the first resin composition film 12a may have a thermal conductivity of 0.2 to 0.5 W/mK.

In still another embodiment, the first resin composition film may have a melting point (Tm) in the range of about 280 to 320°C.

In still another embodiment, the first resin composition film may have a peel strength in the range of 0.7 to 1.5 kgf/cm with respect to the first metal foil 13A. The peel strength may be measured according to the IPC TM-650.2.4.8 test standard.

### Step S300: Step of preparing second unit member

The second resin composition C2 prepared in step S100 is applied onto one surface of the continuously supplied second metal foil 13B, followed by drying, thereby preparing a roll-type first unit member Unit-B including the second metal foil 13B and a second resin composition film 12b.

Specifically, the second resin composition is applied onto one surface of the second metal foil 13B, which is continuously supplied from second metal foil supply rollers, followed by drying at about 100 to 180°C, thereby preparing a roll-type second unit member Unit-B in which a film 12b (hereinafter, referred to as "second resin composition film 12b"), obtained by removal of the solvent from the applied second resin composition C2, is formed on one surface of the second metal foil 13B. As such, the roll-type second unit member Unit-B can be prepared by coating and drying the second resin composition C2 directly on the second metal foil 13B without a filming process (paste extrusion and calendering) and a high-temperature firing process. The second resin composition film 12b can enhance the durability of a final flexible metal laminate due to excellent adhesive strength to the second metal foil 13B.

However, when the first unit member Unit-A and the second unit member Unit-B are identical, step S300 is omitted, and only the foregoing step S200 is performed to form two unit members, which are then used.

Since the features of the second metal foil 13B, coating method, and the drying process of the second resin composition overlap with those of the first metal foil 13A, coating method, and the drying process of the first resin composition in the foregoing step S200, the descriptions thereof are omitted.

As shown in FIG. 1, the second unit member Unit-B manufactured through the present step includes the second metal foil 13B and the second resin composition film 12b disposed on one surface of the second metal foil 13B. Particularly, the second metal foil 13B and the second resin composition film 12b are integrated with each other.

In one embodiment, the second resin composition film 12b may have a porosity of about 80 to 100%.

In another embodiment, the first resin composition film 12a may have a thermal conductivity of 0.2 to 0.5 W/mK.

In still another embodiment, the second resin composition film 12b may have a melting point (Tm) in the range of about 280 to 320°C.

In another embodiment, the second resin composition film 12b may have a peel strength in the range of 0.7 to 1.5 kgf/cm with respect to the second metal foil 13B. The peel strength may be measured according to the IPC TM-650.2.4.8 test standard.

### Step S400: Step of binding first unit member, fiber-containing substrate, and second unit member

The first and second unit members Unit-A and Unit-B, obtained in steps S200 and S300, respectively, are laminated on both surfaces of a fiber-containing substrate 11, followed by heating and pressing. The first and second unit members Unit-A and Unit-B are laminated on the fiber-containing substrate 11 such that the resin composition films 12a and 12b of the respective unit members are in contact with the fiber-containing substrate 11.

Specifically, in step S400, the roll-type first unit member Unit-A is laminated on one surface of the fiber-containing substrate 11, continuously supplied from fiber-containing substrate supply rollers while the roll-type second unit member Unit-B is laminated on the other surface of the fiber-containing substrate 11, followed by thermal compression at about 300 to 340°C. Particularly, the respective unit members Unit-A and Unit-B are continuously supplied and laminated such that the resin composition films 12a and 12b of the respective unit members are in contact with the insulating member 11, followed by thermal compression.

The fiber-containing substrate 11, which is a part supporting a final flexible metal laminate 10, can improve low dielectric constant and low loss characteristics of the flexible metal laminate due to the fibers contained therein. Additionally, the fiber-containing substrate 11 can exhibit excellent flexibility, heat resistance, and adhesive strength since the fiber-containing substrate is in close contact with the first and second resin composition films 12a and 12b during manufacturing.

In one embodiment, the fiber-containing substrate 11 may be an aggregate of fibers (fibre assemblies).

In another embodiment, the fiber-containing substrate 11 may be a prepreg containing an aggregate of fibers (fibre assemblies) and a semi-cured resin impregnated with the aggregate of fibers and having a thermal decomposition temperature of 390°C or higher (specifically, about 400°C or higher). Herein, the semi-cured resin may be a resin in a B-stage (semi-cured) state achieved by impregnating an aggregate of fibers with a high heat-resistant resin composition with a thermal decomposition temperature of 390°C or higher (specifically, about 400°C or higher), followed by heating.

The aggregate of fibers (fibre assemblies) may be a plurality of fibers, or a fiber substrate composed of fibers, such as yarns, a woven fabric, a non-woven fabric, a knitting, or a braid.

Non-limiting examples of the fibers may include: vegetable fibers, such as cotton and hemp; animal fibers, such as wool and silk; regenerated fibers such as rayon; synthetic fibers, such as polyester, acryl, nylon, and polyurethane; inorganic fibers, such as glass fibers and carbon fibers; and metal fibers. These may be used alone or in mixture of two or more types. Among these, inorganic fibers like glass fibers and carbon fibers have a low moisture content, which prevents pore formation in the fiber-containing substrate 11 during subsequent curing, and also have excellent thermal stability.

Examples of the aggregate of fibers may include a plurality of glass fibers (e.g., E-glass, D-glass, S-glass, NE-glass, T-glass, and Q-glass), glass paper, glass roving, glass yarn, woven fabric, glass chopped strands, glass chopped strands mats, glass roving cloth, and glass surfacing mats, but are not limited thereto.

The semi-cured resin usable in the present invention is a cured product obtained by semi-curing (B-staging) a high heat-resistant resin composition with a thermal decomposition temperature of 390°C or higher (specifically, 400°C or higher). The high heat-resistant resin composition usable in the present invention is not particularly limited as long as it is commonly used in prepreg in the art and has a thermal decomposition temperature of 390°C or higher (specifically, 400°C or higher).

In one embodiment, the high heat-resistant resin composition may contain at least one type of high heat-resistant resin selected from the group consisting of an epoxy resin and a fluoropolymer, and may optionally further contain a curing agent.

In the high heat-resistant resin composition, the epoxy resin is a thermocurable resin, and can enhance the adhesive strength between prepreg and a resin layer by forming a three-dimensional network structure after curing. Additionally, the epoxy resin can also improve reliability in heat resistance of a flexible metal laminate due to excellent heat resistance, water resistance, and moisture resistance. In addition, the epoxy resin has excellent mechanical strength, electrical insulation, chemical resistance, dimensional stability, and moldability, as well as excellent compatibility with other resins.

The epoxy resin usable in the present invention is a polymer containing at least one epoxide group in the molecule thereof, and preferably does not contain a halogen atom such as bromine in the molecule thereof. In addition, the epoxy resin may contain silicone, urethane, polyimide, polyamide, or the like in the molecule thereof, as well as a phosphorus atom, a sulfur atom, and a nitrogen atom, in the molecule thereof.

Non-limiting examples of the epoxy resin include: bisphenol A epoxy resin, bisphenol F epoxy resin, and hydrogenated products thereof; glycidyl ether-based epoxy resins, such as phenol novolac epoxy resin and cresol novolac epoxy resin; glycidyl ester-based epoxy resins, such as hexahydrophthalic acid glycidyl ester and dimer acid glycidyl ester; glycidyl amine-based epoxy resins, such as triglycidyl isocyanurate and tetraglycidyldiamino diphenylmethane; and linear aliphatic epoxy resins, such as epoxidated polybutadiene and epoxidated soybean oil. These may be used alone or in mixture of two or more types thereof.

In the high heat-resistant resin composition, the fluoropolymer is a thermoplastic resin with excellent chemical stability and high-temperature thermal stability and is a type of heat-resistant resins having a melting point (Tm) of about 260°C or higher. Examples of the fluoropolymer include polytetrafluoroethylene resin (PTFE), perfluoroalkoxy alkane (PFA), tetrafluoroethylene-hexafluoropropylene copolymer resin (FEP), polychlorotrifluoroethylene resin (PCTFE), ethylene-tetrafluoroethylene copolymer resin (ETFE), ethylene-chlorotrifluoroethylene copolymer resin (ECTFE), tetrafluoroethylene-chlorotrifluoroethylene copolymer (TFE/CTFE), polyvinylidene fluoride resin (PVDF), polyvinyl fluoride resin (PVF), tetrafluoroethylene-perfluoroalkyl vinyl ether-hexafluoropropylene copolymer resin (EPE), and the like, but are not limited thereto.

In the high heat-resistant resin composition, the curing agent is a component that cures an epoxy resin, and is not particularly limited as long as it is typically known to cure an epoxy resin, and examples thereof may include acid anhydride-based curing agents, amine-based curing agents, phenol-based curing agents, and the like.

Specifically, examples of the curing agent include: acid anhydride-based curing agents, such as tetrahydrophthalic anhydride, methyl tetrahydrophthalic anhydride, methyl hexahydrophthalic anhydride, hexahydrophthalic anhydride, trialkyl tetrahydrophthalic anhydride, methyl cyclohexenedicarboxylic anhydride, phthalic anhydride, maleic anhydride, and pyromellitic anhydride; aromatic amine-based curing agents, such as metaphenylenediamine, diaminodiphenylmethane, and diaminodiphenylsulfone; aliphatic amine-based curing agents, such as diethylenetriamine and triethylenetetraamine; phenol-based curing agents, such as phenol-aralkyl phenolic resin, phenol-novolac phenolic resin, XYLOK phenolic resin, cresolnovolac phenolic resin, naphthol phenolic resin, terpene phenolic resin, multifunctional phenolic resin, dicyclopentadiene-based phenolic resin, naphthalene phenolic resin, and novolac phenolic resin synthesized from bisphenol A and resol; and potential curing agents, such as dicyandiamide, but are not limited thereto. These may be used alone or in mixture of two or more thereof.

The content of the curing agent is not particularly limited, and may be, for example, about 1 to 10 parts by weight, specifically about 1 to 6 parts by weight, relative to 100 parts by weight of the high heat-resistant resin (e.g., epoxy resin).

The thickness of the foregoing fiber-containing substrate 11 is not particularly limited, and may be, for example, in the range of about 10 to 30 µm. If the thickness of the fiber-containing substrate 11 is in the range of about 10 to 50% of the thickness of the flexible metal laminate, the thermal and mechanical properties of the flexible metal laminate can be further enhanced.

In step S400, heating and pressing may be conducted by using a roll-to-roll device including a hot press or one pair of pressing and heating rollers under a pressure of about 10 to 80 kgf/cm² per meter of the fiber-containing substrate and a temperature of about 300 to 400°C for 0.1 minutes to 1 hour. In one embodiment, the laminate in which the first unit member Unit-A / the fiber-containing substrate 11 /the second unit member Unit-B are laminated in that order may be thermally compressed by using a roll-to-roll device including one pair of heating rollers at a pressure of about 10 to 50 kfg/cm² (e.g., line pressure) for about 0.1 minutes to 1 hour. Each of the resin composition films 12a and 12b has a thermal conductivity as high as of 0.2 to 0.5 W/mK, and thus, even under a short thermal compression time or low thermal compression temperature, the fluoropolymer filler in each film may easily melt with binding to the inorganic filler, and diffuse (migrate) into the fiber-containing substrate 11, and thus be cured as a polymer matrix. Consequently, the first and second resin layers 12A and 12B with (completely) cured resin composition films may be formed in close contact with the fiber-containing substrate 11 and the respective metal foils 13A and 13B, respectively. Therefore, the roll-type flexible metal laminate 10 can be manufactured where the first metal foil 13A/the first resin layer 12A/the fiber-containing substrate 11/the second resin layer 12B/the second metal foil 13B are incorporated as one body.

Hereinafter, the roll-type flexible metal laminate 10 according to the present invention will be described with reference to FIG. 2.

FIG. 2 is a cross-sectional view schematically illustrating a roll-type flexible metal laminate 10 according to an embodiment of the present invention. The roll-type flexible metal laminate 10 (specifically, a roll-type double-sided flexible metal laminate 10) includes: a fiber-containing substrate 11; first and second resin layers 12A and 12B disposed on both surfaces of the fiber-containing substrate 11, respectively; and first and second metal foils 13A and 13B disposed on the resin layers, respectively. The first resin layer 12A contains a first high heat-resistant binder and a first fluoropolymer filler and is a cured product of the foregoing first resin composition C1. The second resin layer 12B is the same as or different from the first resin layer, and contains a second high heat-resistant binder and a second fluoropolymer filler and is a cured product of the foregoing second resin composition C2. As such, the first and second resin layers 12A and 12B each are formed of a resin composition containing a high heat-resistant binder with low dielectric properties and a high thermal decomposition temperature and a fluoropolymer filler with a low dielectric constant, and thus the roll-type flexible metal laminate 10 according to the present invention exhibits excellent low dielectric properties, interlayer adhesiveness, and heat resistance. The roll-type flexible metal laminate 10 according to the present invention exhibits excellent low dielectric properties as well as excellent thermal and mechanical properties by including the fiber-containing substrate 11 interposed between the first resin layer 12A and the second resin layer 12B, and thus the roll-type flexible metal laminate 10 can be used in printed circuit boards for high-frequency to ultra-high frequency applications.

Since the features of the fiber-containing substrate 11 overlap with those described with respect to the method for manufacturing a flexible metal laminate, the descriptions thereof are omitted.

The first and second resin layers 12A and 12B are disposed on both surfaces of the fiber-containing substrate 11 and serve as insulating layers as well as bonding layers for bonding the first and second metal foils 13A and 13B onto both surfaces of the fiber-containing substrate 11.

The first resin layer 12A is an insulating layer formed by applying the first resin composition directly onto one surface of the first metal foil 13A, followed by drying and subsequent curing, wherein the first resin composition contains a first high heat-resistant binder, a first fluoropolymer filler, and a first organic solvent and may optionally further contain a first inorganic filler and/or a first additive. Therefore, the first resin composition 12A may contain the first high heat-resistant binder and the first fluoropolymer filler and may optionally further contain the first inorganic filler and/or the first additive.

In addition, the second resin layer 12B is an insulating layer formed by applying the second resin composition directly onto one surface of the second metal foil 13B, followed by drying and subsequent curing, wherein the second resin composition contains a second high heat-resistant binder, a second fluoropolymer filler, and a second organic solvent, and may optionally further contain a second inorganic filler and/or a second additive. Therefore, the second resin composition 12B may contain the second high heat-resistant binder, the second fluoropolymer filler and may optionally further contain the second inorganic filler and/or the second additive.

Since the features of the first and second resin compositions overlap with those described with respect to the method for manufacturing a flexible metal laminate, the descriptions thereof are omitted.

The first and second resin layers 12A and 12B may each have a fluorine (F) content in the range of 30 to 80 wt% relative to the total amount of the corresponding layer. The thermal decomposition temperatures of the first and second resin layers 12A and 12B may each be 400°C or higher.

The first resin layer 12A may have a peel strength in the range of 0.7 to 1.5 kgf/cm with respect to the fiber-containing substrate 11 and a peel strength in the range of 0.7 to 1.5 kgf/cm with respect to the first metal foil 13A. The second resin layer 12B may have a peel strength in the range of 0.7 to 1.5 kgf/cm with respect to the fiber-containing substrate 11 and a peel strength in the range of 0.7 to 1.5 kgf/cm with respect to the second metal foil 13B. The peel strength may be measured according to the test standard of IPC TM-650.2.4.8.

The first and second resin layers 12A and 12B may each have an elastic modulus (Young's modulus) of about 0.5 to 7 GPa. In such a case, the mechanical properties of the flexible metal laminate according to the present invention can be improved.

The first and second resin layers 12A and 12B may each have a coefficient of thermal expansion (CTE) of about 10 to 50 ppm/°C. In such a case, the flexible metal laminate of the present invention can effectively improve the flexure characteristics, low expansion, mechanical strength (toughness), and low stress effects of printed circuit boards.

The thicknesses of the first and second resin layers 12A and 12B are not particularly limited, and for example, may be about 5 to 50 µm. The thickness of each of the resin layers is adjusted considering the thickness of each of the metal foils and the flexible metal laminate. For example, the ratio (D₂/D₁) of the resin layer thickness (D₂) to the metal foil thickness (D₁) may be about 2 to 10.

Since the features of the first and second metal foils 13A and 13B overlap with those described with respect to the method for manufacturing a flexible metal laminate, the descriptions thereof are omitted.

The foregoing roll-type flexible metal laminate 10 according to an embodiment of the present invention may have a dielectric loss tangent (Df) of about 0.0003 to 0.003 and a dielectric constant (Dk) of 2.0 to 3.0 in the frequency band of about 1 to 100 GHz since the first resin layer 12A - the fiber-containing substrate 11 - the second resin layer 12B is interposed between the first metal foil 13A and the second metal foil 13B.

In the roll-type flexible metal laminate 10 according to the present invention, a portion where the first resin layer 12A, the fiber-containing substrate 11, and the second resin layer 12B are laminated in that order, that is, a laminate with a structure of the first resin layer 12 - the fiber-containing substrate 11 - and the second resin layer 12B may satisfy all of the properties (i) to (iii) below. Such a flexible metal laminate 10 of the present invention exhibits excellent mechanical properties, heat resistance, and durability.
(i) a coefficient of thermal expansion (CTE) in the range of 10 to 50 ppm in the MD axis;
(ii) a Young's modulus in the range of 0.5 to 7 GPa; and
(iii) a tensile strength in the range of 2 to 200 MPa.

### <Printed Circuit Board>

The present invention provides a printed circuit board (PCB) including the foregoing roll-type flexible metal laminate and, specifically, provides a flexible printed circuit board (FPCB).

In one embodiment, the printed circuit board may include a flexible metal laminate, and circuit patterns may be formed in the metal foils (first metal foil and/or second metal foil) included in the flexible metal laminate. The first resin layer - the fiber-containing substrate - the second resin layer included in the flexible metal laminate serves as an insulating support member. The flexible metal laminate may be the foregoing roll-type flexible metal laminate itself, or may be a unit body obtained by cutting the roll-type flexible metal laminate into predetermined units.

In another embodiment, the printed circuit board may include: a flexible metal laminate; and one or more laminates disposed on the flexible metal laminate, wherein the laminates may each include a third resin layer and a third metal foil disposed on the third resin layer. The third resin layer, which is an interlayer insulating layer, may be a resin layer formed of the foregoing first or second resin composition, or a resin layer formed of a resin known in the art, such as polyimide. The flexible metal laminate may be the foregoing roll-type flexible metal laminate itself, or may be a unit body obtained by cutting the roll-type flexible metal laminate into predetermined units.

The printed circuit board of the present invention may be manufactured by a typical method known in the art. For example, while a roll-type flexible metal laminate is continuously supplied by using a roll-to-roll device, holes are formed in the flexible metal laminate, followed by through hole plating, and then metal foils (e.g., copper foils) including plating films are etched to form circuits, thereby manufacturing a printed circuit board.

The foregoing printed circuit board of the present invention includes a flexible metal laminate having a low dielectric constant and a dielectric loss tangent at the frequency band of about 1 GHz to 100 GHz, and thus can ensure a low dielectric loss at the frequency band of about 1 GHz to 100 GHz, consequently a transmission loss. Hence, the printed circuit board of the present invention can be advantageously applied to mobile communication devices managing high-frequency or ultra-high frequency signals, network-related electronic devices, such as base station devices, servers, and routers, and various electrical, electronic, and communication devices, such as large-scale computers and automotive radar systems.

Hereinafter, the present invention has been described in detail through embodiments, but the following examples and experimental examples are only for illustrating an embodiment of the present invention, and the scope of the present invention is not limited to the following examples and experimental examples.

### [Preparation Example 1] and [Comparative Preparation Example 1]

Resin compositions having the compositions shown in Table 1 below was prepared separately. Specifically, SiOi (average particle diameter (D50): 12 µm) was dispersed in MEK as a solvent, and then PFA as a fluoropolymer filler and FKM as a heat-resistant binder were dispersed therein, thereby preparing a resin composition. In Table 1 below, the unit of content of each component was " wt%", which was based on the total amount of a corresponding resin composition (provided that a solvent is excluded), and the unit of content of a solvent was " part(s) by weight", which was based on 100 parts by weight of a corresponding resin composition (provided that a solvent is excluded).

**TABLE 1**

| | | Preparation Example 1 | Comparative preparation example 1 |
|---|---|---|---|
| Fluoropolymer resin | PFA | 65 | 65 |
| Inorganic filler | SiO₂ | 30 | 30 |
| Fluorine-based elastomer | FKM | 5 | - |
| | NBR | - | 5 |
| Solvent | MEK | 43 | 43 |
| * PFA: Perfluoroalkoxy alkanes (Tm: 315°C, MFR: 1~30 g/10 min, average particle diameter: 0.01-30 µm, maximum particle diameter: 30 µm) | | | |
| * SiO₂ | | | |
| * FKM: Fluoro elastomer copolymer (thermal decomposition temperature: about 400°C) | | | |
| * NBR: Nitrile-butadiene rubber (thermal decomposition temperature: 220°C) | | | |
| * MEK: Ethyl methyl ketone | | | |

### [Example 1]

### 1-1. Manufacturing of first and second unit members

The resin composition of Preparation Example 1 was coated to a thickness of 45 µm, by using one pair of coating rollers, on one surface of a copper foil (thickness: 12 µm, roughness (Rz): 1.5 µm or less) continuously supplied from copper foil supply rollers, and then the applied resin composition was dried at about 140°C for about 3 minutes, thereby manufacturing a roll-type first unit member in which a first resin composition film was formed on one surface of the first copper foil.

Meanwhile, a roll-type second unit member in which a second resin composition film was formed on one surface of a second copper foil was manufactured by using the same process for manufacturing a first unit member.

### 1-2. Manufacturing of roll-type double-sided flexible metal laminate

The first and second roll-type unit members separately manufactured in Example 1-1 were laminated on both surface of a prepreg, which was continuously supplied from prepreg supply rollers, and then the laminated product was thermally compressed at a pressure of 80 kgf/cm for shorter than 1 hour at a temperature of 300 °C or higher by using one pair of high-temperature roll presses, thereby manufacturing a roll-type flexible metal laminate. The unit members were laminated such that the composition films in the respective unit members were in contact with the surface of the prepreg.

### [Comparative Example 1]

A roll-type flexible metal laminate was manufactured by the same method as in Example 1 except that the resin composition of Comparative Preparation Example 1 was used instead of the resin composition of Preparation Example 1 used in Example 1-1.

### [Comparative Example 2]

The first unit member and the second unit member were laminated such that the resin layers of the first and second unit members separately manufactured in Example 1-1 were in contact with each other, and then the laminated product was thermally compressed at a pressure of 80 kgf/cm for shorter than 1 hour at a temperature of 300 °C or higher by using one pair of high-temperature roll presses, thereby manufacturing a roll-type flexible metal laminate.

### [Experimental Example 1]

The portions remaining excluding the copper foils in the roll-type flexible metal laminates respectively manufactured in Example 1 and Comparative Examples 1 and 2 were measured for properties as follows, and the results are shown in Table 2.

### (1) Preparation

According to the IPC TM 650 2.5.5.9 evaluation standard, each of the flexible metal laminates was impregnated with an etching solution (hydrochloric acid:hydrogen peroxide = 1:2 volume ratio) to remove the copper foils, and then the remaining portion (e.g., first resin layer - prepreg - second resin layer; or first resin layer - second resin layer) was subjected to the following experiment.

### (2) Coefficient of Thermal Expansion (CTE, ppm)

The coefficient of thermal expansion was measured using Thermo Mechanical Analyzer (TMA) according to the IPC-650 2.4.41 test standard.

### (3) Young Modulus (GPa) and Tensile Strength (MPa)

The Young modulus and tensile strength were separately measured using Universal Testing Machine (UTM) according to the IPC TM-650 2.4.4/ASTM D3039 test standard.

### (4) Adhesiveness to copper foil

During the manufacturing according to the roll-to-roll process in Example 1 and Comparative Examples 1 to 2, a laminate (first unit member - prepreg - second unit member) before thermal compression was wound around a roller for about 1 hour, and then unwound from the roller. Thereafter, it was observed with the naked eye whether the semi-cured resin composition film and the copper foil in the unwound laminate were detached. Meanwhile, the laminate before thermal compression was punched by a punching machine (punching size: 4cm×4cm) and then it was observed with the naked eye whether the semi-cured resin composition film and the copper foil in the unwound laminate at the edge of the hole were detached. The result was marked as "Pass" if there was no detachment between the resin composition film and the copper foil in both the tests, and marked as "Fail" if there was a detachment between the resin composition film and the copper foil in any of the tests.

**TABLE 2**

| | Example 1 | Comparative Example 1 | Comparative Example 2 |
|---|---|---|---|
| Coefficient of thermal expansion (ppm) | 18 | 95 | 68 |
| Young modulus (GPa) | 2.9 | 0.8 | 0.9 |
| Tensile strength (MPa) | 79 | 10 | 6 |
| Adhesiveness | Pass | Pass | Fail |

## Claims

1. A method for manufacturing a roll-type flexible metal laminate, the method comprising:
preparing a first resin composition, which contains a first high heat-resistant binder, a first fluoropolymer filler, and a first organic solvent, and a second resin composition, which is the same as or different from the first resin composition and contains a second high heat-resistant binder, a second fluoropolymer filler, and a second organic solvent;
applying the first resin composition onto one surface of a first metal foil, which is continuously supplied, followed by drying at 100 to 180°C, thereby preparing a first roll-type unit member containing the first metal foil and a first resin composition film;
applying the second resin composition onto one surface of a second metal foil, which is continuously supplied, followed by drying at 100 to 180°C, thereby preparing a second roll-type unit member containing the second metal foil and a second resin composition film; and
laminating the first and second unit members on both surfaces of a fiber-containing substrate, which is continuously supplied, respectively, such that the composition films of the unit members are in contact with the surfaces of the fiber-containing substrate, followed by heating and pressing at 300 to 400°C.

2. The method of claim 1, wherein the first resin composition further contains a first inorganic filler, and
the second resin composition further contains a second inorganic filler, which is the same as or different from the first inorganic filler.

3. The method of claim 1, wherein the first and second resin composition films each have a melting point in the range of 280 to 320°C.

4. The method of claim 1, wherein the first resin composition film has a peel strength in the range of 0.7 to 1.5 kgf/cm with respect to the first metal foil, and
the second resin composition film has a peel strength in the range of 0.7 to 1.5 kgf/cm with respect to the second metal foil.

5. The method of claim 1, wherein the heating and pressing is conducted under a pressure of 10 to 80 kgf/cm² per meter of the fiber-containing substrate and a temperature of 300 to 400 °C for 0.1 minutes to 1 hour.

6. A roll-type flexible metal laminate, comprising:
a fiber-containing substrate;
a first resin layer disposed on one surface of the substrate;
a second resin layer disposed on the other surface of the substrate, the second resin layer being the same as or different from the first resin layer; and
first and second metal foils disposed on the first and second resin layers, respectively,
wherein the first resin layer contains a first high heat-resistant binder and a first fluoropolymer filler, and
the second resin layer is the same as or different from the first resin layer and contains a second high heat-resistant binder and a second fluoropolymer filler.

7. The flexible metal laminate of claim 6, wherein the first resin layer further contains a first inorganic filler, and
the second resin layer further contains a second inorganic filler, which is the same as or different from the first inorganic filler.

8. The flexible metal laminate of claim 6, wherein the first and second high heat-resistant binders each have a thermal decomposition temperature of 400°C or higher.

9. The flexible metal laminate of claim 6, wherein the first and second fluoropolymer fillers each have a melting point (Tm) of 280 to 320°C.

10. The flexible metal laminate of claim 6, wherein the first and second fluoropolymer fillers each have a maximum particle diameter of 0.01 to 30 µm.

11. The flexible metal laminate of claim 6, wherein the content of the first fluoropolymer filler is in the range of 40 to 95 wt% relative to the total amount of the first resin layer, and
the content of the second fluoropolymer filler is in the range of 40 to 95 wt% relative to the total amount of the second resin layer.

12. The flexible metal laminate of claim 6, wherein the first and second resin layers each have a fluorine (F) content in the range of 30 to 80 wt% relative to the total weight of the corresponding layer.

13. The flexible metal laminate of claim 6, wherein the fiber-containing substrate is a prepreg containing an aggregate of fibers, or an aggregate of fibers and a high heat-resistant resin, with which the aggregate of fibers is impregnated and which has a thermal decomposition temperature of 400°C or higher.

14. The flexible metal laminate of claim 6, wherein the first and second metal foils are the same as or different from each other, each having a roughness (Rz) in the range of 0.5 to 3 µm.

15. The flexible metal laminate of claim 6, wherein the flexible metal laminate has a dielectric loss tangent (Df) of 0.0003 to 0.003 and a dielectric constant (Dk) of 2.0 to 3.0 at 1 to 100 Hz.

16. The flexible metal laminate of claim 6, wherein a portion composed of the first resin layer, the fiber-containing substrate, and the second resin layer satisfies at least any one of the following conditions (i) to (iii):
(i) a coefficient of thermal expansion (CTE) in the range of 10 to 50 ppm in the MD axis;
(ii) a Young's modulus in the range of 0.5 to 7 GPa; and
(iii) a tensile strength in the range of 5 to 250 MPa.

17. The flexible metal laminate of claim 6, wherein the first resin layer has a peel strength in the range of 0.7 to 1.5 kgf/cm with respect to the first metal foil and a peel strength in the range of 0.7 to 1.5 kgf/cm with respect to the fiber-containing substrate, and
the second resin layer has a peel strength in the range of 0.7 to 1.5 kgf/cm with respect to the second metal foil and a peel strength in the range of 0.7 to 1.5 kgf/cm with respect to the fiber-containing substrate.

18. A flexible printed circuit board comprising the roll-type flexible metal laminate of any one of claims 6 to 17.
